# EUROPEAN PATENT APPLICATION

(11) **EP 2 757 694 A1**
(43) Date of publication of application: **23.07.2014**
(21) Application number: 13305055.9
(22) Date of filing: 18.01.2013
(51) Int. Cl.: H03M 7/30, H03M 7/46

(54) **Data compression**

(71) Applicant: Alcatel Lucent, 75007 Paris (FR)
(72) Inventor: Denhez, Alain, 78140 Vélizy (FR)
(74) Representative: ALU Antw Patent Attorneys

(57) **Abstract**

Method for data compression of an input sequence (I) of characters into an output sequence (O), wherein the characters in the input sequence (I) are represented by a k bits code of a set of 2^{k} codes arranged in 2^{l} ranges of 2^{m} successive codes, with I+m=k, the method comprising:
- if the m least significant bits of a character to be encoded (I(i)) differ from at least one predetermined m bits tag (ST) and the range (R(i)) of the character to be encoded (I(i)) is the same as the range (R(i-1)) of the previous character in the input sequence (I), encoding (S9) said character to be encoded (I(i)) into the output sequence with an m bits value (V(i)) corresponding to the m least significant bits of the character to be encoded (I(i)),
- otherwise, encoding (S3) said character to be encoded (I(i)) into the output sequence (O) with said at least one predetermined m bits tag (ST), I bits indicating the range (R(i)) of the character to be encoded (I(i)) and an m bits value (V(i)) corresponding to the m least significant bits of the character to be encoded (I(i)).

## Description

### FIELD OF THE INVENTION

The present invention relates to the field of data compression.

### BACKGROUND

Data compression is useful for a variety of situations. For example, communications often involve transferring relatively large amounts of data between different devices. The data transfer may be streamlined by compressing the data before transmitting it from one device to another. Data compression can increase the amount of information that can be communicated over a given bandwidth. A variety of data compression techniques are known.

Some known data compression techniques may not always result in a smaller file or a smaller amount of information. For example, in the case of small files, some data compression techniques do not introduce any size decrease. In such cases, a data compression technique adds additional processor requirements without providing any savings in terms of file size.

### SUMMARY

It is thus an object of embodiments of the present invention to propose an improved data compression method and device, which do not show the inherent shortcomings of the prior art. Another object of embodiments of the present invention is to propose a corresponding data decompression method and device.

Accordingly, embodiments of the present invention relates to a method for data compression of an input sequence of characters into an output sequence, wherein the characters in the input sequence are represented by a k bits code of a set of 2^{k} codes arranged in 2^{l} ranges of 2^{m} successive codes, with I+m=k, the method comprising:
- if the m least significant bits of a character to be encoded differ from at least one predetermined m bits tag and the range of the character to be encoded is the same as the range of the previous character in the input sequence, encoding said character to be encoded into the output sequence with an m bits value corresponding to the m least significant bits of the character to be encoded,
- otherwise, encoding said character to be encoded into the output sequence with said at least one predetermined m bits tag, l bits indicating the range of the character to be encoded and an m bits value corresponding to the m least significant bits of the character to be encoded.

In an embodiment, k = 8, l = 3, and m = 5.

Each range R may comprise a first flag and a second flag, the m least significant bits of the first flags being equals to a first predetermined tag, the m least significant bits of the second flags being equals to a second predetermined tag.

The method may comprise selecting one of the first predetermined tag and the second predetermined tag in function of the character to be encoded.

For example, the first predetermined tag consists of m bits "0" and the second predetermined tag consists of m bits "1".

Embodiments of the invention relate to a method for compressing a text comprising a plurality of input sequences, comprising:
- determining an output sequence in function of one of the input sequences, according to the method for data compression of one embodiment of the invention,
- selecting the shortest of the input sequence and the output sequence, and
- outputting the selected sequence.

The method may comprise:
- determining an output sequence in function of one of the input sequence, according to the method for data compression of one embodiment of the invention, concurrently with outputting the selected sequence corresponding the previous input sequence.

Embodiment of the invention also relates to a method for compressing a text comprising a plurality of input sequences, comprising:
- determining an output sequence in function of one of the input sequence, according to the method for data compression of one embodiment of the invention,
- outputting the output sequence,
- if the output sequence is not shorter than the input sequence, selecting a no compression mode for the following input sequence.

Determining the output sequence and outputting the output sequence may be executed concurrently.

Embodiments of the invention also relate to a device for data compression of an input sequence of characters into an output sequence, wherein the characters in the input sequence are represented by a k bits code of a set of 2^{k} codes arranged in 2^{l} ranges of 2^{m} successive codes, with I+m=k, the device for data compression comprising:
- means for encoding said character to be encoded into the output sequence with an m bits value corresponding to the m least significant bits of the character to be encoded, activated if the m least significant bits of a character to be encoded differ from at least one predetermined m bits tag and the range of the character to be encoded is the same as the range of the previous character in the input sequence, and
- means for encoding said character to be encoded into the output sequence with said at least one predetermined m bits tag, l bits indicating the range of the character to be encoded and an m bits value corresponding to the m least significant bits of the character to be encoded, activated otherwise.

Embodiments of the invention also relate to a method for data decompression of a sequence of bits into a decompressed sequence of characters, wherein the characters in the decompressed sequence are represented by k bits codes of a set of 2^{k} codes arranged in 2^{l} ranges of 2^{m} successive codes, with I+m=k,
the method comprising:
- if m successive bits of the sequence of bits are equal to at least one predetermined tag:
   - determining the range of a character to be decoded in function of the I following bits of the sequence of bits,
   - determining the value of a character to be decoded in function of the m following bits of the sequence of bits, and,
   - determining the character to be decoded in function of said range and said value,
- otherwise:
   - determining the value of a character to be decoded in function of said m successive bits of the sequence of bits, and,
   - determining a character to be decoded in function of the range of the previous character and said value.

Embodiments of the invention also relate to a device for data decompression of a sequence of bits into a decompressed sequence of characters, wherein the characters in the decompressed sequence are represented by k bits codes of a set of 2^{k} codes arranged in 2^{l} ranges of 2^{m} successive codes, with I+m=k,
the device for data decompression comprising:
- first means, activated if m successive bits of the sequence of bits are equal to at least one predetermined tag, for:
   - determining the range of a character to be decoded in function of the I following bits of the sequence of bits,
   - determining the value of a character to be decoded in function of the m following bits of the sequence of bits, and,
   - determining the character to be decoded in function of said range and said value,
- second means, activated otherwise, for:
   - determining the value of a character to be decoded in function of said m successive bits of the sequence of bits, and,
   - determining a character to be decoded in function of the range of the previous character and said value.

Embodiments of the invention also provide a computer program comprising instructions for performing one of the methods mentioned before when said instructions are executed by a computer.

### BRIEF DESCRIPTION OF THE DRAWINGS

The above and other objects and features of the invention will become more apparent and the invention itself will be best understood by referring to the following description of embodiments taken in conjunction with the accompanying drawings wherein:
Figure 1 shows a coding table used in embodiments of the invention,
Figure 2 is a functional representation of a device for compressing data according to an embodiment of the invention,
Figure 3 is a functional representation of a device for decompressing data according to an embodiment of the invention,
Figure 4 is a structural representation of the device of figure 2 and/or 3,
Figure 5 is a flowchart of a method for compressing data according to embodiments of the invention,
Figure 6 is a flowchart of a method for compressing data in an asynchronous mode, which use the method of figure 5,
Figure 7 is a flowchart of a method for compressing data in a synchronous mode, which use the method of figure 5, and
Figure 8 is a flowchart of a method for decompressing data according to embodiments of the invention.

### DESCRIPTION OF EMBODIMENTS

It is to be remarked that the functions of the various elements shown in the figures may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Their function may be carried out through the operation of program logic, through dedicated logic, through the interaction of program control and dedicated logic, or even manually, the particular technique being selectable by the implementer as more specifically understood from the context.

It should be further appreciated by those skilled in the art that any block diagrams herein represent conceptual views of illustrative circuitry embodying the principles of the invention. Similarly, it will be appreciated that any flow charts represents various processes which may be substantially represented in computer readable medium and so executed by a computer or processor, whether or not such computer or processor is explicitly shown.

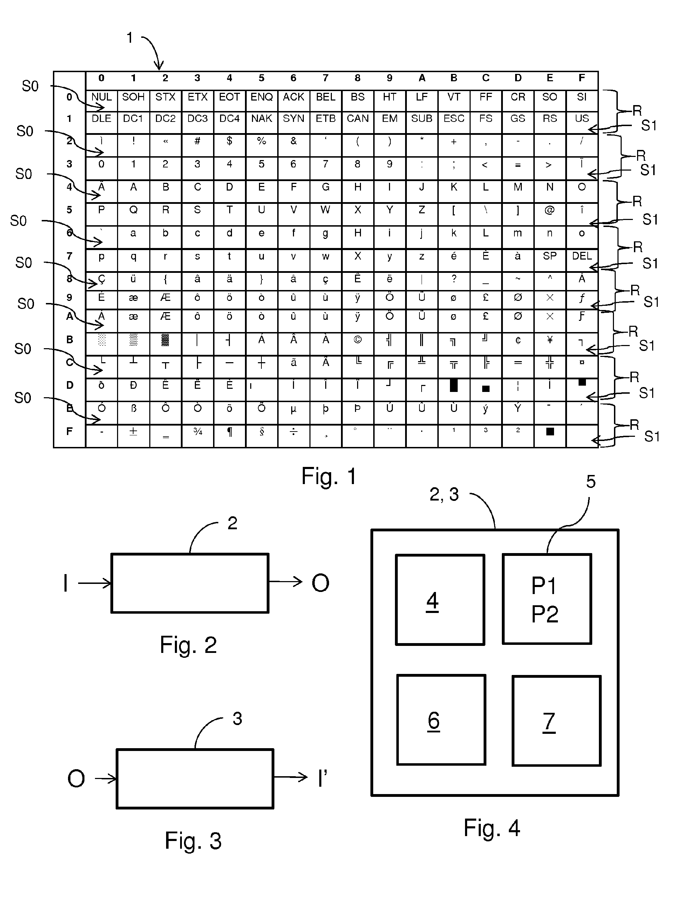

Figure 1 shows a coding table 1 used for coding characters, wherein each character is coded by a corresponding 8 bits code. Figure 1 shows the hexadecimal values of the codes. For example, character "a" is coded as x61 in hexadecimal or as 01100001 in binary. Hereafter, we may refer in short to the bits of a character instead of referring to the bits of the corresponding code.

In coding table 1, the characters are arranged in 8 ranges R of 32 successive codes. For example, one of the ranges R goes from character "Ä" (x40) to character "î" (x5F). Furthermore, each range R is associated with two flags, namely an even flag S0 and an odd flag S1, as shown in figure 1. The even flag S0 is the first character of the range R and the odd flag S1 is the last character of the range R. One will recognize that the even flags S0 share the same 5 least significant bits, namely 00000, and that the odd flags S1 share the same 5 least significant bits, namely 11111. Furthermore, one will recognize that all the characters in a range R share the same 3 most significant bits.

The coding table 1 shown on figure 1 is a modified version of the well-known extended ASCII table. More precisely, with respect to the extended ASCII table:
- 4 characters respectively changed: { , | , } , ∼ , by é, è, à, SP
- 2 characters inter-changed : ^ by @
- 4 characters respectively changed: ? , _ , ∼ , ^ by Ï, î , ì, Ä

This modified version of the ASCII table has the effect that characters appearing often close to each other in usual text messages are placed in the same range R, which leads to improved compression efficiency as will appear later. However, embodiments of the invention may use another coding table, for example the standard extended ASCII table. Furthermore, the description will be continued with reference to the coding table 1 which use 8 bits codes arranged in 8 ranges of 32 successive codes. However, embodiments of the invention may use any other coding table wherein 2^{k} characters are coded with k bits code out of a set of 2^{k} codes arranged in 2^{l} ranges of 2^{m} successive codes, with I+m=k.

Figure 2 is a functional representation of a device for data compression 2. The device for data compression 2 compresses an input sequence I of characters into an output sequence O. Similarly, Figure 3 is a functional representation of a device for data decompression 3. The device for data decompression 3 decompresses the output sequence O, provided by the device for data compression 2, into a decompressed sequence I' equals to the original input sequence I.

**Figure 4** is a structural representation of a device which may be a device for data compression 2 and/or a device for data decompression 3. The device of figure 4 comprises a processor 4, a non-volatile memory 5, a volatile memory 6 and a communication interface 7. The processor 4 allows executing computer programs stored in non-volatile memory 5, using the volatile memory 6 as working memory. The communication interface 7 allows communicating with at least one other device, through a communication link or a network.

The non-volatile memory 5 may comprise a computer program P1, the execution of which implements a method for compressing data, and/or a computer program P2, the execution of which implements a method for decompressing data.

The device of figure 4 may be for example a personal computer, a handheld terminal such as a mobile phone, a server in a communication network...

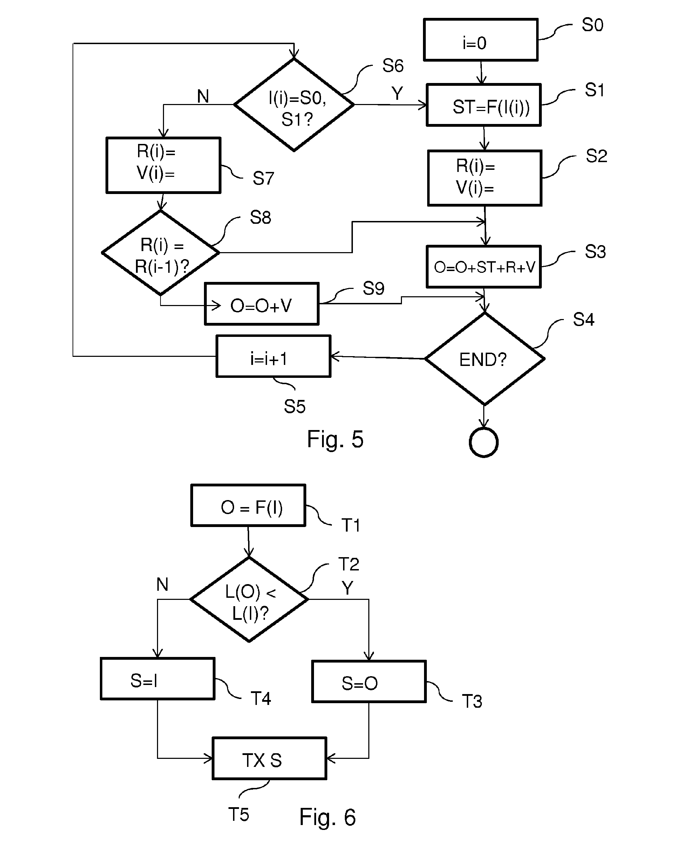

**Figure 5** is a flowchart of a method for compressing data, performed by a device for data compression 2. The method of figure 5 aims at compressing an input sequence I of characters I(i), with i ranging from 0 to L-1, into an output sequence O.

The method begins with a counter i being initialized at 0 (Step S0). Hereafter, the character to be encoded is noted I(i).

Then, a 5 bits synchronization tag ST is determined in function of the character I(i) (step S1). The synchronization tag ST represents a synchronization mode used when compressing data: ST = 11111 correspond to an odd synchronization mode and ST = 00000 correspond to an even synchronization mode.

At step S1, if the character to be encoded I(i) is one of the even flags S0, the even synchronization mode is selected (ST = 00000). On the contrary, if the character to be encoded I(i) is one of the odd flags S1, the odd synchronization mode is selected (ST = 11111). The first time step 1 is executed, the character to be encoded I(i) may not be one of the flags S0 and S1. In that case, a default synchronization mode is selected. The default synchronization mode may be the even or the odd synchronization mode.

Then, the range R(i) and the value V(i) of the character to be encoded I(i) are determined (step S2). The range R(i) correspond to the 3 most significant bits of character I(i) and the value V(i) correspond to the 5 least significant bits of the character I(i).

The character to be encoded I(i) is coded in the output sequence O by 13 bits corresponding to the succession of the synchronization tag ST, the range R(i) and the value V(i) (step S3). This is illustrated as O=O+ST+R+V on figure 5.

After that, the device for data compression 2 determines whether the input sequence I has been completely compressed (step S4). If the input sequence I has been completely compressed, then the method ends. Otherwise, the counter i is incremented by one (step S5) and the method proceed to encoding the next character to be encoded I(i).

The device for compressing data 2 determines whether the character to be encoded I(i) is one of the flags S0 or S1. In the affirmative, the character to be encoded I(i) is encoded according to steps S1 to S3 as described previously. On the contrary, if the character to be encoded I(i) is not one of the flags S0 or S1, then the range R(i) and the value V(i) of the character to be encoded I(i) are determined (step S7) in the same manner as in step S2.

Next, the range R(i) of the character to be encoded is compared to the range R(i-1) of the previous character I(i-1), which had been determined previously at the previous execution of either step S2 or S7.

If the range R(i) of the character to be encoded is the same as the range R(i-1) of the previous character, then character to be encoded I(i) is coded in the output sequence O by 5 bits corresponding to the value V(i) (step S9). This is illustrated as O=O+V on figure 5. Then, the device for data compression 2 proceeds to step S4 described previously.

On the contrary, if the range R(i) of the character to be encoded is different from the range R(i-1) of the previous character, then the device for data compression 2 proceeds to step S3 wherein character to be encoded I(i) is coded in the output sequence by 13 bits corresponding to the succession of the synchronization tag ST, the range R(i) and the value V(i) (step S3).

According to the compression method of Figure 5, an 8 bits character I(i) of the input sequence I is coded in the output sequence O by one of:
- 13 bits for the first character I(0), for a character which is one of the flag S0 and S1 and for a character which is in a different range than the previous character, or
- 5 bits in the other cases.

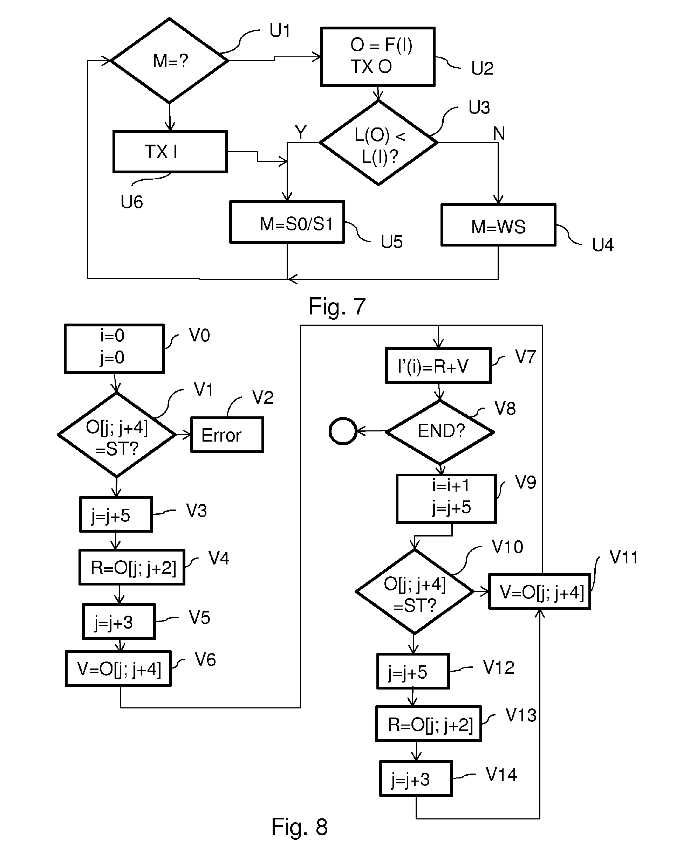

The compression gain G of the method of figure 5 depends on the ratio between characters encoded with 13 bits and characters encoded with 5 bits. In some case, the gain G may be negative. However, assuming that the input sequence I is a usual text message composed mostly of successive alphabetic characters, which belongs to the 3^{rd} and 4^{th} range illustrated on Figure 1, the gain G will generally be positive. Moreover, the effects of a negative gain can be limited with the asynchronous mode method or the synchronous mode method described hereafter with reference to figures 6 and 7.

Moreover, encoding the character I(i) does not require the knowledge of the whole input sequence I. In contrast, a character I(i) may be encoded individually provided that the range R(i-1) of the previous character I(i-1) and the current synchronisation tag ST are known. In other words, the method of figure 5 provides a serial (character by character) compression technique. When the characters I(i) are received successively (for example in a transmission system), this allows encoding I(i) before the complete input sequence I has been received. Buffering, storing and/or transmission of the output sequence O (depending on the considered application of the device for data compression 2) may also start before the complete input sequence I has been received and/or compressed.

**Figure 6** is a flowchart of a method for compressing a text T composed of successive sequences I, according to an asynchronous mode. The method of figure 6 is performed by a device for data compression 2.

The sequences I are processed sequentially according to steps T1 to T5.

A sequence I is compressed into an output sequence O (step T1), according to the serial compression technique described above with reference to figure 5. Step T1 may be executed while buffering/receiving the sequence I.

Then, the length L(O) of the output sequence O, in bits, is compared to the length L(I) of the input sequence I, in bits (step T2). Both lengths L(O) and L(I) may be determined at step T1 by counting the bits received in the input sequence I and the bits added to the output sequence O.

A selected sequence S is chosen depending on this comparison. More precisely, if the output sequence O is shorter than the input sequence I, in other words if the compression method of step T1 has a positive gain G (L(O) < L(I)), then the output sequence O is selected (step T3). On the contrary, if the output sequence O is not shorter than the input sequence I, then the input sequence I is selected (step T4). In other words, after determining the output sequence O at step T1, the shorter sequence is selected at steps T2-T4.

Finally, the selected sequence S is output, for example it is buffered, stored and/or transmitted depending on the application of the device for data compression 2 (step T5).

The output of the selected sequence (step T5) may occur in parallel with the compressing of the next input sequence I of text T (step T1).

According to the asynchronous mode of figure 6, the selected sequences S output when compressing the text T have either the same length as or a shorter length than the corresponding input sequences I. Consequently, even if some of the input sequences are compressed at step T1 with a negative gain G, the global gain for compressing the text T will be positive.

In the asynchronous mode of figure 6, the input sequence has to be received and compressed entirely (step T1) before one of the sequences O and I can be selected and output (step T2-T5). Thus, the asynchronous mode does not fully take advantage of the serial compression as discussed before.

**Figure 7** is a flowchart of a method for compressing a text T composed of successive sequences I, according to a synchronous mode. The method of figure 7 is performed by a device for data compression 2.

A mode M may take one of the three following values:
- WS, meaning that an input sequence I should not be compressed,
- S0, meaning that an input sequence I should be compressed by using the even synchronization mode as the default mode for the first execution of step S1 of figure 5, or
- S1, meaning that an input sequence I should be compressed by using the odd synchronization mode as the default mode for the first execution of step S1 of figure 5.

The mode M may be initialized at WS, S0 or S1. Then, the sequences I are processed sequentially according to steps U1 to U6.

First, the device for compressing data 2 determined if the mode M is WS or S0/S1 (step U1).

If the mode M is one of S0 and S1, then a sequence I is compressed into an output sequence O (step U2), according to the serial compression technique described above with reference to figure 5. For the compression of step U2, the default mode (even or odd) used at step S1 of figure 5 is specified by the mode M.

Step U2 may be executed while buffering/receiving the sequence I. Furthermore, the output sequence O may be output progressively during step U1, for example it may be buffered, stored and/or transmitted (depending of the application of the device for data compression 2).

Then, the length L(O) of the output sequence O, in bits, is compared to the length L(I) of the input sequence I, in bits (step U3). Both lengths L(O) and L(I) may be determined at step U1 by counting the bits received in the input sequence I and the bits added to the output sequence O.

The mode M for processing the following input sequence I is chosen depending on this comparison. More precisely, if the output sequence O is shorter than the input sequence I, in other words if the compression method of step U1 has a positive gain G (L(O) < L(I)), then one of the mode M=S0 and M=S1 is selected (step U5). On the contrary, if the output sequence O is not shorter than the input sequence I, then the mode M=WS is selected (step U4).

In contrast, if at step U1 the mode M is WS, then the input sequence I is output without compression (step U6) and then the mode M for the following sequence is set to S0 or S1 at step U5 previously described.

After step U4 or U5, the processing of the following input sequence I starts at step U1 with the mode M chosen for this sequence I.

According to the synchronous mode compression technique of figure 7, the output sequence O may be output (that is, buffered, stored, transmitted...) progressively, in parallel to the reception and compression of the input sequence I.

The output sequence O may be longer than the corresponding input sequence I, in other words the gain G of the serial compression of step U2 may be negative.

It may be assumed that if the gain G for compressing an input sequence I is negative, then it is likely than the gain G for compressing the following input sequence I will also be negative. This may be the case example if both input sequences I relates to a part of the text T with various special characters involving changes of range R. In view of this, according to the method of figure 7, when the gain is negative G at step U3, the mode M=WS is selected at step U4 and the following input sequence I is not compressed (steps U1 and U6), thereby providing a gain G = 0. This allows limiting the impact of the possible negative gain G of compressing an input sequence I on the total gain for compressing the text T.

In the example of figure 7, only one input sequence I is not compressed after step U6, then the mode M is returned to S0 or S1 at step U5 and the next input sequence I is again compressed. In another example (not shown), more than one input sequence may not be compressed before returning to mode M=S0 or M=S1.

**Figure 8** is a flowchart of a method for decompressing data, performed by a device for data decompression 3. The method of figure 8 aims at decompressing the output sequence O provided by a device for data compression 2, into a decompressed sequence I' equals to the input sequence I used by the device for data compression 2 for determining the output sequence O.

The following notations are used on Figure 8:
- I'(i) refers to the i^{th} 8 bits character of the decompressed sequence I', with i ranging from 0 to L-1, and
- O[j; j+x] refers to the x bits of the output sequence O, starting from the j^{th} bit.

In other words, the counter i refers to 8 bits characters and the counter j refers to individual bits.

First, the counters i and j are initialized at 0 (step V0).

Then, the device for decompressing data 3 determines whether the first five bits O[j; j+4] of the output sequence O correspond to a synchronization tag ST (step V1). Indeed, as is apparent from the description of the method for compressing data of figure 5, the first five bits O[j; j+4] of the output sequence O should normally be one of the synchronization tags 11111 and 00000. If O[j; j+4] is different from 11111 or 00000, an error occurs (step V2).

If no error occurred, then the next three bits of the output sequence O are used to determined the range R of the character I'(i). This is illustrated on figure 8 as incrementing j by 5 (step V3) and determining R in function of O[j; j+2] (step V4).

After that, the next five bits of the of the output sequence O are used to determined the value V of the character I'(i). This is illustrated on figure 8 as incrementing j by 3 (step V5) and determining V in function of O[j; j+4] (step V6).

Then, the character I'(i) is determined in function of the range R and the value V: I'(i) = R + V (step V7).

Then, the counter i and j are incremented for processing the next character: i = i + 1 and j = j +5 (step V9).

After that, the device for decompressing data 3 determines whether the following five bits O[j; j+4] of the output sequence O correspond to a synchronization tag ST (step V10).

If O[j; j+4] is not one of the synchronization tag 11111 and 00000, it means that the character I'(i) is in the same range R as the previous character I'(i-1) and is not one of the flags S0 and S1, and has been encoded only by its 5 bits value V. Therefore, the value V is determined in function of O[j; j+4] (step V11). Then, at step V7, the character I'(i) is determined by using the same range R as for the previous character I'(i).

In contrast, if O[j; j+4] is one of the synchronization tag 11111 and 00000, it means that the character I'(i) is in a different range R than the previous character I'(i-1) and/or is one of the flags S0 and S1, and has been encoded by a 5 bits synchronization tag, a 3 bits range R and a 5 bits value V. Therefore, the next three bits of the output sequence O are used to determine the range R of the character I'(i). This is illustrated on figure 8 as incrementing j by 5 (step V12) and determining R in function of O[j; j+2] (step V13). After that, the next five bits of the output sequence O are used to determined the value V of the character I'(i). This is illustrated on figure 8 as incrementing j by 3 (step V14) and determining V in function of O[j; j+4] (step V11). Finally, at step V7, the character I'(i) is determined by using the updated range R of step V13.

Of course, the loop of steps V7 to V14 ends when the output sequence O has been completely processed. This is for example determined by a test at step V8.

The method for decompression data of figure 8 allows decompressing an output sequence O compressed by the method of compressing data of figure 5. The use of synchronization tags 11111 and 00000 allows determining whether a character I'(i) should be determined based on only a five bit value V of the output sequence O or on a 13 bits group comprising a 5 bits synchronization tag ST, a 3 bits range R and a 5 bits value V.

The following table gives an example of compressing the input sequence « A message is waiting on your voicemail at phone number 888 », of 58 characters, that is 464 bits. The characters are coded with coding table 1. Thus, in particular, the space character is coded as x7E instead of x20.

| **Character of input sequence I** | **Code of input sequence I (hexadecimal)** | **Bits of output sequence O** |
|---|---|---|
| A | 41 | 1111 1010 0 0001 |
| | 7E | 1111 1011 1 1110 |
| m | 6D | 0 1101 |
| e | 65 | 0 0101 |
| s | 73 | 1 0011 |
| s | 73 | 1 0011 |
| a | 61 | 0 0001 |
| g | 67 | 0 0111 |
| e | 65 | 0 0101 |
| | 7E | 1 1110 |
| i | 69 | 0 1001 |
| s | 73 | 1 0011 |
| | 7E | 1 1110 |
| w | 77 | 1 0111 |
| a | 61 | 0 0001 |
| i | 69 | 0 1001 |
| t | 74 | 1 0100 |
| i | 69 | 0 1001 |
| n | 6E | 0 1110 |
| g | 67 | 0 0111 |
| | 7E | 1 1110 |
| o | 6F | 0 1111 |
| n | 6E | 0 1110 |
| | 7E | 1 1110 |
| y | 79 | 1 1001 |
| o | 6F | 0 1111 |
| u | 75 | 1 0101 |
| r | 72 | 1 0010 |
| | 7E | 1 1110 |
| v | 76 | 1 0110 |
| o | 6F | 0 1111 |
| i | 69 | 0 1001 |
| c | 63 | 0 0011 |
| e | 65 | 0 0101 |
| m | 6D | 0 1101 |
| a | 61 | 0 0001 |
| i | 69 | 0 1001 |
| i | 6C | 0 1100 |
| | 7E | 1 1110 |
| a | 61 | 0 0001 |
| t | 74 | 1 0100 |
| | 7E | 1 1110 |
| p | 70 | 1 0000 |
| h | 68 | 0 1000 |
| o | 6F | 0 1111 |
| n | 6E | 0 1110 |
| e | 65 | 0 0101 |
| | 7E | 1 1110 |
| n | 6E | 0 1110 |
| u | 75 | 1 0101 |
| m | 6D | 0 1101 |
| b | 62 | 0 0010 |
| e | 65 | 0 0101 |
| r | 72 | 1 0010 |
| | 7E | 1 1110 |
| 8 | 38 | 1111 1001 1 1000 |
| 8 | 38 | 1 1000 |
| 8 | 38 | 1 1000 |

The output sequence O comprises 314 bits, to be compared to the 464 bits of the input sequence I. The gain G is ((464-314)/464) = 32.3%.

Embodiments of the method can be performed by means of dedicated hardware and/of software or any combination of both.

While the principles of the invention have been described above in connection with specific embodiments, it is to be clearly understood that this description is made only by way of example and not as a limitation on the scope of the invention, as defined in the appended claims.

## Claims

1. Method for data compression of an input sequence (I) of characters into an output sequence (O), wherein the characters in the input sequence (I) are represented by a k bits code of a set of 2^{k} codes arranged in 2^{l} ranges of 2^{m} successive codes, with I+m=k, the method comprising:
- if the m least significant bits of a character to be encoded (I(i)) differ from at least one predetermined m bits tag (ST) and the range (R(i)) of the character to be encoded (I(i)) is the same as the range (R(i-1)) of the previous character in the input sequence (I), encoding (S9) said character to be encoded (I(i)) into the output sequence with an m bits value (V(i)) corresponding to the m least significant bits of the character to be encoded (I(i)),
- otherwise, encoding (S3) said character to be encoded (I(i)) into the output sequence (O) with said at least one predetermined m bits tag (ST), l bits indicating the range (R(i)) of the character to be encoded (I(i)) and an m bits value (V(i)) corresponding to the m least significant bits of the character to be encoded (I(i)).

2. Method according to claim 1, wherein k = 8, l = 3, and m = 5.

3. Method according to one of claims 1 and 2, wherein each range R comprises a first flag (S0) and a second flag (S1), the m least significant bits of the first flags (S0) being equals to a first predetermined tag, the m least significant bits of the second flags (S1) being equals to a second predetermined tag.

4. Method according to claim 3, comprising selecting (S1) one of the first predetermined tag and the second predetermined tag in function of the character to be encoded (I(i)).

5. Method according to one of claims 3 and 4, wherein the first predetermined tag consist of m bits "0" and the second predetermined tag consist of m bits "1".

6. Method for compressing a text (T) comprising a plurality of input sequences (I), comprising:
- determining (T1) an output sequence (O) in function of one of the input sequences (I), according to the method for data compression of one of claims 1 to 5,
- selecting (T2, T3, T4) the shortest of the input sequence (I) and the output sequence (O), and
- outputting (T5) the selected sequence (S).

7. Method according to claim 6, comprising:
- determining (T1) an output sequence (O) in function of one of the input sequence (I), according to the method for data compression of one of claims 1 to 5, concurrently with outputting (T5) the selected sequence (S) corresponding the previous input sequence (I).

8. Method for compressing a text (T) comprising a plurality of input sequences (I), comprising:
- determining (U2) an output sequence (O) in function of one of the input sequence (I), according to the method for data compression of one of claims 1 to 5,
- outputting (U2) the output sequence (O),
- if the output sequence is not shorter than the input sequence, selecting (U4) a no compression mode (M) for the following input sequence (I).

9. Method according to claim 8, wherein determining (U2) the output sequence (O) and outputting (U2) the output sequence (O) are executed concurrently.

10. Device for data compression (2) of an input sequence (I) of characters into an output sequence (O), wherein the characters in the input sequence (I) are represented by a k bits code of a set of 2^{k} codes arranged in 2^{l} ranges of 2^{m} successive codes, with I+m=k, the device for data compression (2) comprising:
- means for encoding (S9) said character to be encoded (I(i)) into the output sequence (O) with an m bits value (V(i)) corresponding to the m least significant bits of the character to be encoded (I(i)), activated if the m least significant bits of a character to be encoded (I(i)) differ from at least one predetermined m bits tag (ST) and the range (R(i)) of the character to be encoded (I(i)) is the same as the range (R(i-1)) of the previous character in the input sequence (I), and
- means for encoding (S3) said character to be encoded (I(i)) into the output sequence (O) with said at least one predetermined m bits tag (ST), l bits indicating the range (R(i)) of the character to be encoded (I(i)) and an m bits value (V(i)) corresponding to the m least significant bits of the character to be encoded (I(i)), activated otherwise.

11. Computer program comprising instructions for performing the method of one of claims 1 to 9 when said instructions are executed by a computer.

12. Method for data decompression of a sequence of bits (O) into a decompressed sequence (I') of characters, wherein the characters in the decompressed sequence (I') are represented by k bits codes of a set of 2^{k} codes arranged in 2^{l} ranges of 2^{m} successive codes, with I+m=k,
the method comprising:
- if m successive bits of the sequence of bits (O) are equal to at least one predetermined tag (ST):
- determining (V12, V13) the range (R(i)) of a character to be decoded (I'(i)) in function of the l following bits of the sequence of bits (O),
- determining (V14, V11) the value (V(i)) of a character to be decoded (I'(i)) in function of the m following bits of the sequence of bits (O), and,
- determining (V7) the character to be decoded (I'(i)) in function of said range (R(i)) and said value (V(i)),
- otherwise:
- determining (V11) the value (V(i)) of a character to be decoded (I'(i)) in function of said m successive bits of the sequence of bits (O), and,
- determining (V7) a character to be decoded (I'(i)) in function of the range of the previous character and said value (V(i)).

13. Device for data decompression (3) of a sequence of bits (O) into a decompressed sequence (I') of characters, wherein the characters in the decompressed sequence (I') are represented by k bits codes of a set of 2^{k} codes arranged in 2^{l} ranges of 2^{m} successive codes, with I+m=k,
the device for data decompression (3) comprising:
- first means, activated if m successive bits of the sequence of bits (O) are equal to at least one predetermined tag (ST), for:
- determining (V12, V13) the range (R(i)) of a character to be decoded (I'(i)) in function of the l following bits of the sequence of bits (O),
- determining (V14, V11) the value (V(i)) of a character to be decoded (I'(i)) in function of the m following bits of the sequence of bits (O), and,
- determining (V7) the character to be decoded (I'(i)) in function of said range (R(i)) and said value (V(i)),
- second means, activated otherwise, for:
- determining (V11) the value (V(i)) of a character to be decoded (I'(i)) in function of said m successive bits of the sequence of bits (O), and,
- determining (V7) a character to be decoded (I'(i)) in function of the range of the previous character and said value (V(i)).

14. Computer program comprising instructions for performing the method of claim 12 when said instructions are executed by a computer.
